# FASCICULE DE BREVET EUROPEEN

(11) **EP 0 996 930 B1**
(45) Date de publication et mention de la délivrance du brevet: **02.11.2006**
(21) Numéro de dépôt: 99919315.4
(22) Date de dépôt: 10.05.1999
(51) Int. Cl.: G06K 19/073

(54) **SUPPORT POUR UN CIRCUIT ELECTRONIQUE, COMPRENANT DES MOYENS ANTI-ARRACHEMENT**
UNTERLAGE FÜR ELEKTRISCHE SCHALTANORDNUNG MIT MITTELN DIE ENTKOPPELN VERMEIDEN
ELECTRONIC CIRCUIT SUPPORT COMPRISING TEAR RESISTANT MEANS

(30) Priorité: 20.05.1998 FR 9806361
(43) Date de publication de la demande: 03.05.2000
(73) Titulaire: CP8 TECHNOLOGIES, 78431 Louveciennes (FR)
(72) Inventeur: LE LOC'H, Alain, F-78000 Versailles (FR)
(74) Mandataire: Cassagne, Philippe M.J.
(86) Numéro de dépôt international: PCT/FR1999/001106
(87) Numéro de publication internationale: WO 1999/060518

(56) Documents cités:
- EP-A- 0 716 394
- FR-A- 2 724 750

## Description

L'invention concerne un support pour un circuit électronique, le circuit électronique portant au moins un plot de contact, le support comprenant un élément isolant logeant le circuit électronique et portant, sur une face extérieure, une couche conductrice définissant au moins une plage de contact, ledit plot de contact au moins prévu étant relié à ladite plage de contact.

Un support de ce genre est notamment connu dans le domaine de la carte à puce, du type carte de crédit ou autre, décrite par exemple dans le document US-A-4.211.919, et utilisée par un usager pour obtenir des produits ou services, ou pour accéder à un lieu. Dans ce cas, plusieurs plots de contact sont prévus, qui permettent à la carte de coopérer avec un terminal lecteur de carte dans lequel elle est insérée. Le support est rapporté dans un évidement pratiqué dans la carte, et y est fixé, notamment par collage.

Un moyen de fraude connu consiste, pour s'affranchir d'éventuelles informations identifiant le porteur légitime de la carte et apposées à la surface de celle-ci (telles qu'un numéro, une inscription, ou une photo), à retirer le support d'une carte authentique et à le fixer sur une carte frauduleuse. Il faut, à cet effet, décoller le support sans le détériorer.

Il est connu par le document FR-A-2 724 750, dans le domaine des cartes électroniques avec un voyant de bon fonctionnement, un autre genre de support pour élément électrooptique et circuit électronique de contrôle. Ce support peut comprendre des rainures de fragilisation, comme indiqué dans le préambule de la revendication 1, pour éviter une falsification par décollement de la carte. Toutefois, le type de support décrit dans ce document est inadapté pour d'autres utilisations.

L'invention vise à fournir des moyens selon la revendication 1 pour rendre détectable, voire inopérante l'opération de retrait frauduleux du support.

Selon l'invention, le support est caractérisé en ce qu'il comporte au moins une zone de fragilité située dans l'élément isolant. Ainsi, lors d'une tentative de retrait du support par laquelle une contrainte est exercée sur lui, celui-ci sera détérioré en raison de la présence de la zone de fragilité : la zone de fragilité occasionnera des déformations qui pourront être visualisées sur la couche conductrice ; ces déformations conduiront même souvent à rendre inopérant le support , car elles auront provoqué la rupture du circuit électronique ou de sa liaison avec la plage de contact.

D'autres détails et avantages de la présente invention apparaîtront au cours de la description suivante de quelques formes de réalisation préférées mais non limitatives, en regard des dessins annexés sur lesquels :
La figure 1 est une vue en perspective d'un support de circuit électronique constitué par une carte à puce équipée d'un bouton logeant un circuit électronique ;
La figure 2 est une vue en plan partielle et agrandie de la figure 1, montrant le bouton selon l'invention ;
La figure 3 est une vue en coupe transversale, selon la ligne III-III de la figure 2 ;
La figure 4 est une vue en plan d'un bouton, selon une variante de réalisation de l'invention ;
La figure 5 est une vue en plan d'un bouton, selon une autre variante de réalisation de l'invention ;
La figure 6 est une vue en coupe transversale, selon la ligne VI-VI de la figure 5 ;
La figure 7 est une vue en plan d'un bouton, selon une autre variante de réalisation de l'invention ;
La figure 8 est une vue en coupe transversale, selon la ligne VIII-VIII de la figure 7 ;
La figure 9 est une vue en coupe transversale d'un bouton, selon une autre variante de réalisation de l'invention ;
La figure 10 est une vue en plan d'un bouton, selon une autre variante de réalisation de l'invention ; et
La figure 11 est une vue en coupe transversale, selon la ligne XI-XI de la figure 10.

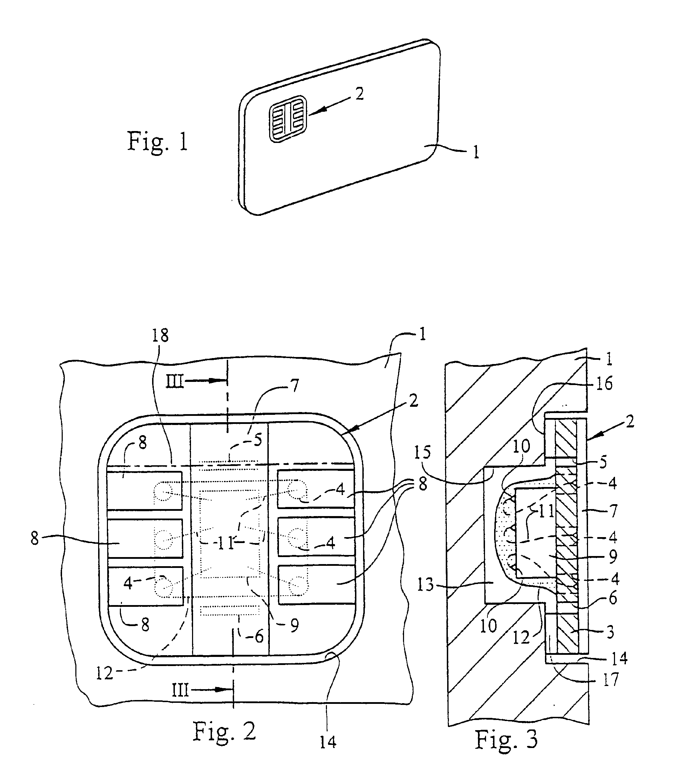

Sur la figure 1 est représenté un support de circuit électronique constitué par une carte à puce 1. Celle-ci porte un bouton 2 contenant un circuit électronique et agencé pour coopérer électriquement avec un lecteur de carte connu en soi et non représenté.

Le bouton 2 apparaît en détail sur les figures 2 et 3. Il comprend une couche isolante électriquement 3 comportant plusieurs trous de liaison électrique 4 et deux zones de fragilité 5, 6 décrites en détail ci-après. Une face extérieure de la couche isolante 3 porte une couche conductrice , notamment en cuivre, composée de plusieurs plages de contact dont une plage de contact centrale 7 s'étendant, dans cet exemple, sur toute une longueur du bouton et six plages de contact périphériques 8 réparties de part et d'autre de la plage de contact centrale 7. Une face intérieure de la couche isolante 3 porte un circuit électronique 9 collé sur celle-ci et comprenant typiquement une mémoire et éventuellement des moyens de traitement tels qu'un microprocesseur. Le circuit électronique 9 porte, sur une face éloignée de la couche isolante 3, des plots de contact 10 (six, dans cet exemple) reliés respectivement aux six plages de contact périphériques 8 par un fil de liaison 11. Chaque fil de liaison 11 traverse un trou de liaison électrique correspondant 4 et est soudé sur un plot et sur la plage de contact correspondante 8 de façon connue en soi. Enfin, un enrobage isolant électriquement 12 recouvre le circuit électronique 9 et les trous de liaison électrique 4 de la couche isolante 3, à l'exclusion des zones de fragilité 5,6.

Les trous de liaison électrique 4 sont situés face aux plages de contact 8. Les zones de fragilité 5,6 sont constituées par des rainures situées en face de la plage de contact centrale 7 et s'étendant linéairement, perpendiculairement à elle. Elles sont situées de part et d'autre du circuit électronique 9. Les trous de liaison électrique 4 et les zones de fragilité 5,6 traversent toute l'épaisseur de la couche isolante 3 ; ils sont réalisés, notamment soit par perforation de la couche isolante, avant collage de la couche conductrice sur celle-ci, soit par moulage dans le cas d'une couche isolante moulée, soit encore par gravure au moyen d'un faisceau laser.

Les couches isolante 3 et conductrice 7 ont, vues en plan, une forme sensiblement carrée, présentant des bords arrondis. Afin de loger le bouton 2 dans l'épaisseur de la carte, celle-ci présente un évidement 13 s'étendant sur une partie seulement de l'épaisseur de la carte et constitué d'une partie extérieure 14 présentant une forme carrée destinée à loger les couches isolante 3 et conductrice 7 du bouton, et d'une partie intérieure 15 plus étroite, destinée à loger le circuit électronique 9 et l'enrobage 12 du bouton.

Le bouton 2 s'appuie sur un épaulement 16 de la carte, reliant les parties extérieure 14 et intérieure 16 de l'évidement 13. Une couche de colle 17 est interposée entre l'épaulement 16 et le bouton 2.

En ce qui concerne les dimensions à adopter, les valeurs typiques suivantes sont proposées, à adapter en fonction des formes de réalisation des figures 2 à 11 :
- épaisseur de la couche conductrice : 35 à 70 microns
- épaisseur de la couche isolante 3 : 100 à 150 microns
- épaisseur du circuit électronique 9 : 135 à 225 microns
- épaisseur totale du bouton 2 : 500 à 600 microns
- rayon de courbure des trous de liaison électrique 4 : typiquement supérieur ou égal à 400 microns
- largeur des zones de fragilité : 100 à 500 microns, de préférence 200 à 400 microns
- profondeur des zones de fragilité : 50 à 250 microns, de préférence vers 200 microns
- rayon de courbure dans des angles des zones de fragilité : de préférence inférieur à 50 microns
- rapport longueur sur largeur des zones de fragilité : de 10 à 60

Les valeurs indiquées ci-dessus montrent bien la différence entre les trous de liaison électrique 4 et les zones de fragilité 5,6. Les trous de liaison électrique 4 sont des cylindres à grand rayon de courbure : en raison de cette forme, ils sont impropres à se rompre sous la contrainte et ne peuvent donc jouer le rôle de zones de fragilité. En revanche, les zones de fragilité sont des rainures, c'est-à-dire des évidements allongés et étroits, dont les angles présentent un faible rayon de courbure : cette forme est propre à provoquer une rupture des zones de fragilité dans les angles et le long de celles-ci.

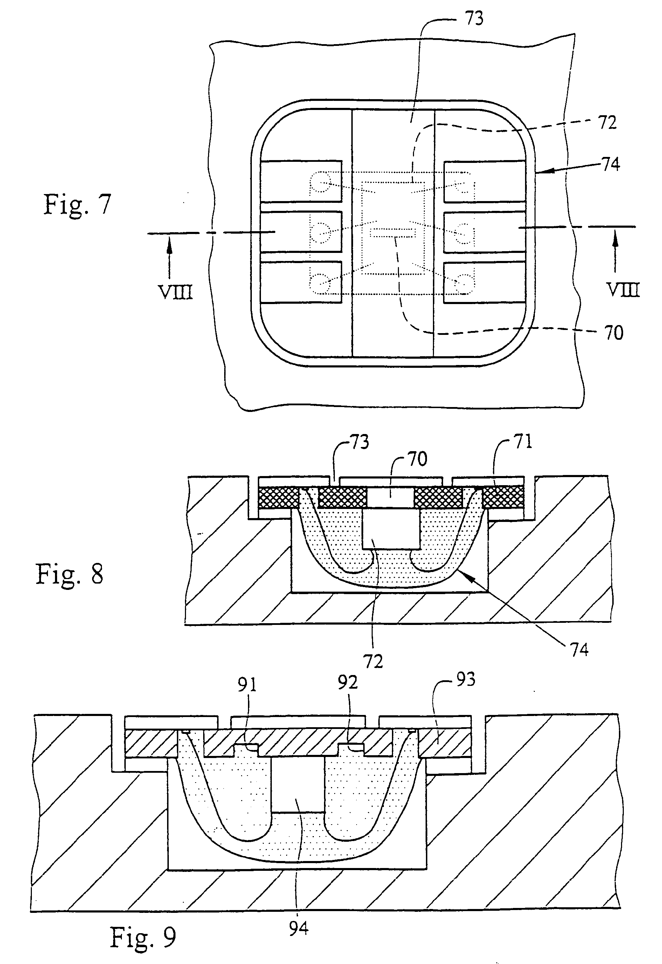

Par ailleurs, les matériaux utilisés sont avantageusement les suivants :
- couche conductrice : cuivre
- couche isolante : verre époxy ou polyester
En ce qui concerne l'enrobage, le matériau sera choisi en fonction des formes de réalisation. Dans le cas où l'enrobage n'est pas susceptible de pénétrer dans les zones de fragilité (figures 3,4,8,11), on pourra utiliser une résine relativement rigide, à savoir la résine époxy. En revanche, dans le cas où l'enrobage est susceptible de pénétrer dans les zones de fragilité (figures 6,9), on choisira de préférence un matériau plus souple, à savoir la résine silicone, de façon à ne pas neutraliser l'effet de fragilisation procuré par la présence des zones de fragilité.

En utilisation, si un fraudeur tente de décoller le bouton 2 en vue par exemple de le loger dans une carte non authentique, en insérant un outil entre le bouton 2 et la partie extérieure 14 de l'évidement 13, la couche isolante 3 va tendre à se plier le long des zones de fragilité 5,6. Un premier effet observable à l'oeil est une déformation de la plage de contact 7 de la couche conductrice , dans une région située en face des zones de fragilité : cette déformation, du type pli ou boursouflure, pourra être détectée par un agent de contrôle effectuant une vérification de la carte. Dans le cas où le fraudeur déforme davantage le bouton, un second effet peut éventuellement être observé, consistant en une cassure de la couche isolante 3 et/ou de la couche conductrice le long d'une ligne 18 passant par les zones de fragilité 5,6.

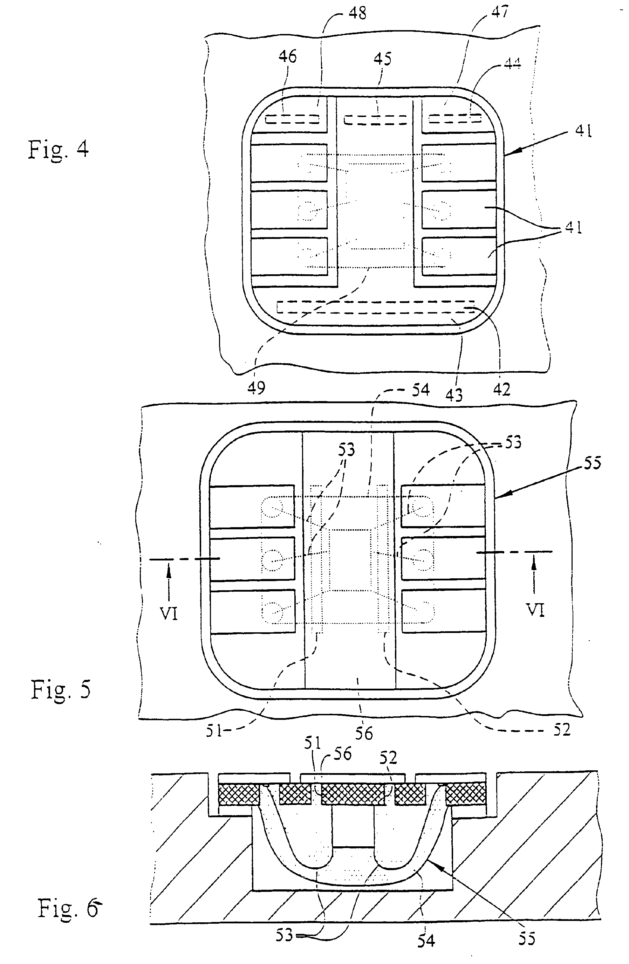

Selon la variante de la figure 4, des plages de contact recouvrent sensiblement toute la surface du bouton 41. Les zones de fragilité sont disposées en fonction des plages de contact et comprennent, d'un côté du bouton, une rainure 42 s'étendant sur une plage de contact 43 sur presque toute la largeur du bouton 41 et, d'un côté opposé du bouton, trois rainures 44 à 46 disposées respectivement sur trois plages de contact 47,43,48 et alignées entre elles. Les zones de fragilité sont encore situées à l'extérieur de l'enrobage 49. De préférence, comme représenté sur cette figure, les zones de fragilité ne s'étendent pas en dehors des plages de contact.

En utilisation, si un fraudeur tente de décoller le bouton 41, les effets sont semblables à ceux relatifs aux figures 2,3.

Selon la variante des figures 5 et 6, les zones de fragilité 51,52 comprennent deux rainures s'étendant dans la couche isolante, en face des fils de liaison 53, sensiblement perpendiculairement à eux. Elles s'étendent sur une longueur voisine de la largeur de l'enrobage 54. Elles traversent encore la couche isolante sur toute son épaisseur. Compte tenu de leur position, les zones de fragilité sont remplies par l'enrobage 54, ce qui n'est pas préjudiciable à leur fonction si, comme indiqué précédemment, l'enrobage est constitué par un matériau suffisamment souple.

En utilisation, si un fraudeur tente de décoller le bouton 55, un premier effet consistera en la déformation, observable à l'oeil, de la plage de contact 56. Un second effet consistera en la sollicitation des fils de liaison 53, qui seront soumis à une tension allant jusqu'à la rupture : dans ce cas, le bouton est hors d'usage.

Dans l'exemple des figures 7 et 8, une seule zone de fragilité 70 est prévue, qui comprend une rainure s'étendant sur toute l'épaisseur de la couche isolante 71, en face du circuit électronique 72. Une plage de contact centrale 73 s'étend sur toute la largeur du bouton 74 et la zone de fragilité 70 s'étend perpendiculairement à la plage de contact centrale, sur une longueur voisine de la largeur du circuit électronique 72.

En utilisation, si un fraudeur tente de décoller le bouton 74, un premier effet consistera en la déformation, observable à l'oeil, de la plage de contact 73. Un second effet consistera en la sollicitation du circuit électronique 72, pouvant aller jusqu'à la rupture de celui-ci le long de la zone de fragilité 70, mettant hors d'usage le bouton 74.

Dans l'exemple de la figure 9, les zones de fragilité 91,92 ne sont pas constituées par des rainures traversantes mais par un amincissement de la couche isolante 93. Ces zones de fragilité sont réalisées sur une face intérieure de la couche isolante, tournée vers le circuit électronique 94. En utilisation, les effets de la présence de ces zones de fragilité sont semblables à ceux décrits pour les figures 5,6.

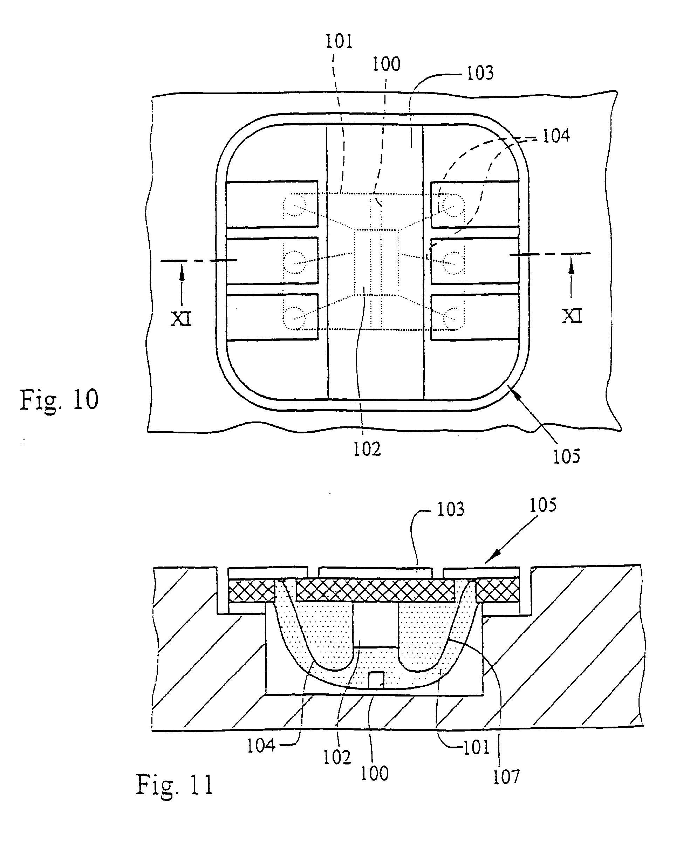

Dans l'exemple des figures 10,11, une zone de fragilité unique 100 est pratiquée dans l'enrobage 101. Cette zone de fragilité est une rainure pratiquée sur une surface extérieure de l'enrobage, en face du circuit électronique 102, et s'étendant le long d'une plage de contact centrale 103, sensiblement perpendiculairement à des fils de liaison 104. La zone de fragilité 100 est notamment réalisée par gravure au moyen d'un faisceau laser ou par usinage mécanique. Le cas échéant, une seconde zone de fragilité, semblable à la première et perpendiculaire à elle, peut être prévue.

En utilisation, si un fraudeur tente de décoller le bouton 105, l'effet consistera essentiellement en la sollicitation du circuit électronique 102, pouvant aller jusqu'à la rupture de celui-ci le long de la zone de fragilité 100, mettant hors d'usage le bouton 105.

Dans ce qui précède, on a vu que les zones de fragilité pouvaient, selon leur localisation, soit seulement endommager le bouton, soit le mettre hors d'usage. Lorsque les zones de fragilité ne sont pas situées au droit du circuit électronique ou de ses fils de liaison, mais à proximité des plages de contact, le bouton est endommagé : il peut encore éventuellement fonctionner. Un fraudeur peut même éventuellement arriver à réparer ou remplacer les plages de contact endommagées, puisqu'elles sont extérieures au bouton. En revanche, lorsque les zones de fragilité sont situées au droit du circuit électronique ou de ses fils de liaison, elles entraînent une rupture de ceux-ci, qui rend le bouton hors d'usage : dans ce cas, la rupture étant interne au bouton elle est pratiquement irréparable.

L'invention n'est naturellement pas limitée à la façon dont le circuit électronique est relié aux plages de contact. Dans les exemples précédents, cette liaison est faite par des fils de liaison. Une variante parmi d'autres consiste à disposer une face du circuit électronique portant des plots de contact vers les plages de contact, et à effectuer un soudage direct entre les plots de contact et les plages de contact. De façon plus générale, l'invention s'applique à tout bouton portant un circuit électronique et au moins une plage de contact, quelle que soit la conception et la forme extérieure du bouton, les zones de fragilité étant prévues dans un volume isolant dans lequel est logé le circuit électronique.

L'invention s'applique naturellement, non seulement dans le domaine de la carte à puce, mais aussi dans tout autre domaine où un support de circuit électronique analogue est utilisé et risque d'être arraché par un fraudeur.

## Revendications

1. Support pour un circuit électronique (9, 72, 94), le circuit électronique portant au moins un plot de contact (10), le support comprenant un élément isolant (3,12) logeant le circuit électronique et portant une couche conductrice définissant au moins une plage de contact (7,8), ledit plot de contact (10) au moins prévu étant relié à ladite plage de contact (7, 8),
au moins une zone de fragilité (5,6) étant située dans l'élément isolant (3,12),
et une face extérieure sur laquelle est positionnée ladite couche conductrice ;
le support est **caractérisé en ce qu'**il comporte,
sur un côté dit intérieur opposé à ladite face extérieure, un enrobage (12) couvrant le circuit électronique ; et
ladite zone de fragilité (5,6) située dans l'élément isolant (3,12) pouvant être recouverte par l'enrobage (12) prévu sur le côté intérieur.

2. Support selon la revendication 1, dans lequel la zone de fragilité comprend une rainure (5,6 ; 51,52 ; 70 ; 100).

3. Support selon la revendication 1, dans lequel la zone de fragilité (5,6 ; 51,52 ; 70) est située à proximité de la couche conductrice.

4. Support selon la revendication 1, dans lequel la zone de fragilité (70 ; 100) est située à proximité d'une face principale du circuit électronique (72 ; 102).

5. Support selon la revendication 1, dans lequel au moins un fil de liaison (53,54) relie le plot de contact à la plage de contact (7, 8), la zone de fragilité s'étendant de façon à être chevauchée par ledit fil de liaison.

6. Support selon la revendication 1, dans lequel l'élément isolant comprend l'enrobage (12) et une couche isolante (3) sur laquelle est fixé le circuit électronique (9), ladite zone de fragilité étant située dans la couche isolante.

7. Support selon la revendication 6, dans lequel la zone de fragilité comprend un trou (5,6) traversant la couche isolante (3).

8. Support selon la revendication 6, dans lequel la zone de fragilité comprend un amincissement (91,92) de la couche isolante (93).

9. Support selon la revendication 1, dans lequel l'élément isolant comprend l'enrobage (12) et une couche isolante (3) sur laquelle est fixé le circuit électronique (9), ladite zone de fragilité étant située dans l'enrobage.

10. Support selon la revendication 1, dans lequel ledit plot de contact (10) est relié à ladite plage de contact (7,8) par des moyens de liaison électrique (11,53), lesdits moyens de liaison électrique formant, avec le circuit électronique (9, 72, 94), un ensemble électronique, ladite zone de fragilité étant située au droit dudit ensemble électronique.

## Claims

1. Support for an electronic circuit (9,72,94), the electronic circuit carrying at least one contact block (10), the support comprising an insulating element (3,12) housing the electronic circuit and carrying a conductive layer defining at least one contact pad (7,8), said specified contact block (10) being connected to said contact pad (7,8) at least one brittleness zone (5,6) being situated in the insulating element (3,12), and an outer face on which is positioned said conductive layer, the support is **characterized by** the fact that it comprises, on a so-called interior side opposite said outer face, an encapsulation (12) covering the electronic circuit;
and said brittleness zone (5,6) situated in the insulating element (3,12) possibly being covered by the encapsulation (12) foreseen on the interior side.

2. Support according to claim 1, in which the brittleness zone comprises a groove (5,6; 51,52; 70; 100).

3. Support according to claim 1, in which the brittleness zone (5,6; 51,52; 70) is located close to the conductive layer.

4. Support according to claim 1, in which the brittleness zone (70; 100) is situated close to the main face of the electronic circuit (72; 102).

5. Support according to claim 1, in which at least one jumper (53,54) connects the contact block to the contact pad (7,8), the brittleness zone extending so as to be overlapped by said jumper.

6. Support according to claim 1, in which the insulating element comprises the encapsulation (12) and an insulating layer (3) on which the electronic circuit (9) is fixed, said brittleness zone being located in the insulating layer.

7. Support according to claim 6, in which the brittleness zone comprises a hole (5,6) crossing through the insulating layer (3).

8. Support according to claim 6, in which the brittleness zone comprises a thinning (91,92) of the insulating layer (93).

9. Support according to claim 1, in which the insulating element comprises the encapsulation (12) and an insulating layer (3) on which an electronic circuit (9) is fixed, said brittleness zone being situated in the encapsulation.

10. Support according to claim 1, in which said contact block (10) is connected to said contact pad (7,8) by means of electrical connectors (11,53) said electrical connectors forming an electronic unit with the electronic circuit (9,72,94), said brittleness zone being situated to the right of said electronic unit.

## Patentansprüche

1. Träger für einen elektronischen Kreislauf (9, 72, 94), wobei der elektronische Kreislauf mindestens einen Unterbrecherkontakt (10) aufweist, der Träger ein isolierendes Element (3, 12) aufweist, das den elektronischen Kreislauf aufnimmt und eine Leitschicht, die mindestens einen Kontaktbereich (7,8) definiert und der mindestens vorgesehene Unterbrecherkontakt (10) mit dem mindestens vorhandenen Kontaktbereich (7,8) verbunden ist,
wobei mindestens ein empfindlicher Bereich (5,6) im isolierenden Element (3, 12) liegt,
und eine Außenseite, auf die die Leitschicht aufgebracht ist;
der Träger wird **dadurch gekennzeichnet, dass** er auf der einen Seite, Innenseite gennant, gegenüber der Außenseite eine Umhüllung umfasst, die den elektronischen Kreislauf abdeckt; und der empfindlicher Bereich genanntes Bereich (5,6) in dem isolierenden Element (3,12) liegt, von der Umhüllung (12) abgedeckt werden kann, die auf der Innenseite vorgesehen ist.

2. Träger gemäß Anspruch 1, in dem der empfindliche Bereich eine Rille (5,6; 51, 52; 70; 100) umfasst.

3. Träger gemäß Anspruch 1, in dem der empfindliche Bereich (5,6; 51, 52; 70) in der Nähe der Leitschicht liegt.

4. Träger gemäß Anspruch 1, in dem der empfindliche Bereich (70; 100) in der Nähe einer Hauptseite des elektronischen Kreislaufs (72, 102) liegt.

5. Träger gemäß Anspruch 1, in dem mindestens ein Verbindungsdraht (53, 54) den Unterbrecherkontakt mit dem Kontaktbereich (7,8) verbindet, wobei der empfindliche Bereich so liegt, dass der Verbindungsdraht damit überlappt.

6. Träger gemäß Anspruch 1, in dem das isolierende Element die Umhüllung (12) und eine isolierende Schicht (3) umfasst, auf der der elektronische Kreislauf (9) angebracht ist, wobei der empfindliche Bereich in der isolierenden Schicht liegt.

7. Träger nach Anspruch 6, bei dem der empfindliche Bereich ein Loch (5,6) umfasst, das durch die Isolierschicht (3) verläuft.

8. Träger nach Anspruch 6, bei dem der empfindliche Bereich eine Verdünnung (91,92) der Isolierschicht (93) umfasst.

9. Träger nach Anspruch 1, bei dem das isolierende Element die Umhüllung (12) und eine Isolierschicht (3) umfasst, auf der der elektronische Kreislauf befestigt ist, wobei der empfindliche Bereich in der Umhüllung liegt.

10. Träger nach Anspruch 1, bei dem der Unterbrecherkontakt (10) mit dem Kontaktbereich (7,8) über elektrische Verbindungsmittel (11,53) verbunden ist, wobei die elektrischen Verbindungen mit dem elektronischen Kreislauf (9, 72, 94) eine elektronische Einheit bilden und der empfindliche Bereich in Höhe der elektronischen Einheit liegt.
